# EUROPÄISCHE PATENTSCHRIFT

(11) **EP 3 097 140 B1**
(45) Veröffentlichungstag und Bekanntmachung des Hinweises auf die Patenterteilung: **20.02.2019**
(21) Anmeldenummer: 14824843.8
(22) Anmeldetag: 23.12.2014
(51) Int. Cl.: B32B 27/12, H01L 51/00, C08J 5/18, C08J 7/06, B32B 7/12

(54) **VERFAHREN ZUM ENTFERNEN VON PERMEATEN AUS FLÄCHENGEBILDEN**
PROCESS FOR REMOVING PERMEATES FROM SURFACES
PROCÉDÉ D'ÉLIMINATION DE PERMÉATS DE SURFACES

(30) Priorität: 20.01.2014 DE 102014200948
(43) Veröffentlichungstag der Anmeldung: 30.11.2016
(73) Patentinhaber: tesa SE, 22848 Norderstedt (DE)
(72) Erfinder: KEITE-TELGENBÜSCHER, Klaus, 22529 Hamburg (DE); SCHUH, Christian, 22767 Hamburg (DE); REICHENBACH, Anita, 27305 Bruchhausen-Vilsen (DE)
(86) Internationale Anmeldenummer: PCT/EP2014/079132
(87) Internationale Veröffentlichungsnummer: WO 2015/106940

(56) Entgegenhaltungen:
- EP-A1- 1 407 818
- EP-A1- 2 607 439
- DE-A1-102011 089 565
- JP-A- H0 191 861
- US-A- 6 059 860
- US-A1- 2003 143 423
- US-A1- 2007 142 484
- US-A1- 2010 261 006
- US-A1- 2010 272 933
- US-A1- 2013 140 545
- US-B1- 6 291 061

## Beschreibung

Die Erfindung betrifft das technische Gebiet der Entfernung von Permeaten aus Flächengebilden. Es wird insbesondere ein Verfahren zum Entfernen von besonders geringen Permeatmengen aus einem Flächengebilde vorgeschlagen, welches in organischen elektronischen Anordnungen verwendet wird.

Das Entfernen von Permeaten - beispielsweise von Wasser - aus Flächengebilden ist im Prinzip bereits aus der allgemeinen Lebenserfahrung bekannt. Ein Beispiel ist das Trocknen von Pflanzen oder deren Teilen, z.B. der Blätter, für das Anlegen eines Herbariums. Dabei werden häufig die zu trocknenden Pflanzenteile zwischen Papierblätter gelegt und verpresst, so dass ein enger Kontakt entsteht. Durch den Druck wird zum einen Feuchtigkeit aus den Pflanzenteilen in das aufnehmende Papier gepresst, während der langen Lagerdauer findet aber auch eine Diffusion von Wasser aus den Pflanzenteilen in das Papier statt, so dass die Pflanzenteile getrocknet werden. Um eine Beschädigung der getrockneten Pflanzenteile beim Entnehmen derselben zu vermeiden, darf keine Haftung zwischen ihnen und den trocknenden Papierblättern auftreten.

Dieses Verfahren ist allerdings nur geeignet, den Wassergehalt der Pflanzenteile auf wenige Prozent zu reduzieren, da dann die Gleichgewichtsfeuchte des trocknenden Mediums (hier des Papiers) erreicht ist und dieses keine Feuchtigkeit mehr aufnehmen kann. Das Verfahren ist also nicht geeignet, um sehr niedrige Wassergehalte in einem zu trocknenden Flächengebilde zu erreichen, etwa unterhalb von einem Prozent.

Derart niedrige Permeatgehalte, z.B. Wassergehalte, sind aber insbesondere bei der Herstellung, der Lagerung, dem Transport und der Verarbeitung von Komponenten von elektronischen Aufbauten, insbesondere von organischen elektronischen Aufbauten, in der Regel erforderlich, da diese anderenfalls geschädigt werden.

(Opto)elektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen davon. Die entsprechenden Produkte sind je nach gewünschter Anwendung starr oder flexibel ausgebildet, wobei eine zunehmende Nachfrage nach flexiblen Anordnungen besteht. Die Herstellung derartiger Anordnungen erfolgt häufig durch Druckverfahren wie Hochdruck, Tiefdruck, Siebdruck, Flachdruck oder auch so genanntes "non impact printing" wie etwa Thermotransferdruck, Tintenstrahldruck oder Digitaldruck. Vielfach werden aber auch Vakuumverfahren wie beispielsweise Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet. Die Strukturierung erfolgt in der Regel durch Masken.

Als Beispiele für bereits kommerziell erhältliche oder in ihrem Marktpotential interessante organische bzw. anorganische elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt; ferner Elektrolumineszenzlampen, Licht emittierende elektrochemische Zellen (LEECs), organische Solarzellen wie Farbstoff- oder Polymersolarzellen; weiter anorganische Solarzellen, insbesondere Dünnschichtsolarzellen, zum Beispiel auf der Basis von Silizium, Germanium, Kupfer, Indium und Selen, oder Perowskitsolarzellen; organische Feldeffekt-Transistoren, organische Schaltelemente, organische optische Verstärker, organische Laserdioden, organische oder anorganische Sensoren oder auch organisch- oder anorganisch basierte RFID-Transponder.

Als technische Herausforderung für die Realisierung einer ausreichenden Lebensdauer und Funktion von (opto)elektronischen Anordnungen auf dem Gebiet der anorganischen und organischen (Opto)Elektronik, ganz besonders der organischen Optoelektronik, ist ein Schutz der darin enthaltenen Komponenten vor Permeaten zu sehen. Als Permeate werden dabei in der Regel gasförmige oder flüssige Stoffe angesehen, die in einen Festkörper eindringen und diesen gegebenenfalls durchdringen beziehungsweise durchwandern. Dementsprechend können viele niedermolekulare organische oder anorganische Verbindungen Permeate sein, wobei im vorliegend beschriebenen Zusammenhang Wasserdampf und Sauerstoff von besonderer Bedeutung sind.

Eine Vielzahl von elektronischen Anordnungen - besonders bei Verwendung von organischen Materialien - ist sowohl gegen Wasserdampf als auch gegen Sauerstoff empfindlich. Während der Lebensdauer der elektronischen Anordnungen ist deshalb ein Schutz durch eine Verkapselung erforderlich, da andernfalls die Leistung über den Anwendungszeitraum nachlässt. Bei mangelhaftem Schutz können sich beispielsweise durch Oxidations- oder Hydrolyseprozesse bei Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kurzer Zeit drastisch verringern.

Neben dem Schutz vor eindringenden Permeaten ist aber auch die Entfernung schädlicher Permeate aus vielen im Aufbau der elektronischen Anordnung selbst verwendeten Materialien unbedingt notwendig. Insbesondere die bei flexiblen Aufbauten häufig verwendeten polymeren Substrat-, Abdeck- oder Verklebungsfolien enthalten selbst oft schädliches Permeat, insbesondere Wasser, so dass diese Materialien aufwändig getrocknet werden müssen.

Weiterhin werden insbesondere bei der kontinuierlichen Herstellung von flächigen elektronischen Anordnungen Materialien eingesetzt, die nur als Hilfsmaterialien fungieren, wie z.B. temporäre Trägermaterialien, auf denen z.B. diskrete Einheiten platziert und durch aufeinander folgende Prozessierungsstufen transportiert werden. Auch Hilfsmaterialien, von denen nur Teile im Elektronischen Aufbau verbleiben, werden verwendet und sind dementsprechend weitestgehend permeatfrei zur Verfügung zu stellen.

Insbesondere muss beispielsweise eine Trägerfolie, wie sie beim "Laser Induced Thermal Imaging" (LITI) zur Bereitstellung und zum Transfer der organischen lichtemittierenden Schicht verwendet wird, permeatfrei eingesetzt werden, da sie in direktem Kontakt zu den empfindlichen Materialien steht.

Weiterhin werden Zwischenstufen in der Herstellung flächiger elektronischer Aufbauten mitunter mit Materialien beschichtet oder bedruckt, die in wässriger Dispersion vorliegen. So werden z.B. Elektronen- oder Lochtransportschichten aus intrinsisch leitfähigen Polymeren wie Clevios (PEDOT:PSS; Heraeus Precious Metals) hergestellt. Solche Schichten müssen aufwändig zu einem hohen Grad vom Wasser befreit werden, da sie in direktem Kontakt zu den empfindlichen Materialien stehen.

Verfahren zur Trocknung oder zum Trockenhalten von Flächengebilden finden aber auch Verwendung in anderen Anwendungsfeldern, z.B. in der Pharmazie bei der Herstellung und Lagerung von wirkstoffhaltigen Pflastern oder medizinischen Diagnosestreifen; in der chemischen Analytik bei der Extraktion zu analysierender Substanzen oder ganz allgemein zur Abdeckung von Sensoren.

Wirkstoffhaltige Pflaster bzw. Transdermale Therapeutische Systeme (TTS, TDS) wurden 1979 in den Markt eingeführt und werden heute mit einer Reihe von Wirkstoffen in großem Umfang eingesetzt. Mit diesen Systemen, die rein optisch herkömmlichen Pflastern vergleichbar sind, werden Wirkstoffe (z. B. Hormone, Nikotin u. a.) durch die Haut transdermal verabreicht. Der Vorteil dieser Darreichungsform besteht im Übergang des Wirkstoffes in die Blutgefäße unter Umgehung des gastrointestinalen Trakts. Damit wird das Magen-Darm-System geschont und die Verstoffwechselung des Wirkstoffes durch das hepatische System vor Erreichen des Wirkortes reduziert. Weiterhin wird die Patientenakzeptanz (Compliance) verbessert, weil die Applikation der Systeme nicht täglich, sondern nur noch in größeren Zeitabständen erfolgt. Ähnlich verhält es sich mit oral applizierten löslichen Filmen (Oral Dissolvable Films, ODF).

Die Vorteile von TTS und ODF könnten noch deutlicher zum Tragen kommen, wenn die Wirkstoffabgabe aus solchen Systemen interaktiv und kontrolliert erfolgte. Dazu gehört z.B. die Freisetzung oder Mobilisierung von Wirkstoffen durch Permeate, wie z.B. Wasserdampf oder Sauerstoff, die erst nach der Applikation in das System eindringen dürfen. Demzufolge besteht ein Bedarf, solche Wirkstoffpflaster nach der Herstellung von Permeat zu befreien und permeatfrei zu halten sowie am Patienten zur Verfügung zu stellen.

Verfahren zur Aufnahme von Permeaten aus Flächengebilden durch Gettermaterial enthaltende Flächengebilde sind im Stand der Technik grundsätzlich bekannt.

US 6,103,141 beschreibt beispielsweise eine trockenmittelgefüllte Heißschmelzklebemasse, welche in Form eines Klebebands zur Verfügung gestellt wird. Dieses Tape wird auf die Innenseite eines Behälters geklebt, um den Behälterraum trocken zu halten. In einer bevorzugten Ausführung wird die trockenmittelgefüllte Heißschmelzklebemasse auf eine Seite eines Trägermaterials beschichtet und die andere Seite des Trägermaterials mit einem weiteren Klebstoff beschichtet, der dann in der Anwendung die Verbindung zur Behälterwand herstellt. Dieser Aufbau ist dafür bestimmt, den Gasraum innerhalb dessen sich einen empfindliches Gut befindet, trockenzuhalten, hat also keinen Kontakt zu dem zu trocknenden Gut, weshalb die Trocknungszeiten lang sind.

US 6,139,935 beschreibt ein sauerstoffabsorbierendes Label, welches an die Innenseite eines Behälters geklebt wird und ebenfalls den Behälterinnenraum von Sauerstoff frei hält.

In DE 199 13 761 A1 werden eine flächenförmige und aktivierbare Trocknungsvorrichtung zur Verringerung des Feuchtigkeitsgehalts eines die Vorrichtung umgebenden Gasraums und ein Herstellungsverfahren für eine solche Vorrichtung beschrieben. Dabei kann das Trockenmittel auch in eine haftklebrige Schicht eingearbeitet sein. Auch hier wird der Gasraum um das empfindliche Gut getrocknet. Zwangsläufig wird auch das Substrat, auf dem die haftklebrige Schicht befestigt wird, getrocknet, aber dies ist für die Anwendung unerheblich.

Gegenstand der EP 0 582 968 B1 ist ein Folienverbund mit Wasserdampfsperre, der aus einer ersten Kunststofffolie, einer von einem lösungsmittelhaltigen oder lösungsmittelfreien Kleber oder einem Heißschmelzkleber gebildeten Klebschicht, die 10 bis 50 Gew.% fein verteiltes wasserabsorbierendes Polymerpulver (SAP) enthält, sowie einer über diese Klebschicht mit der ersten Kunststofffolie verbundenen zweiten Kunststofffolie besteht. Ein derartiger Folienverbund wird zur Verpackung feuchtigkeitsempfindlicher Produkte verwendet. Die mit Trockenmittel gefüllte wasserabsorbierende Klebschicht verzögert den Durchtritt von Wasser durch den Folienverbund. Es wird somit im Wesentlichen das Eindringen von Wasser in die Verpackung vermindert.

US 6,112,888 offenbart eine heißschmelzklebende Zusammensetzung aus einem Polymer und einem Trockenmittel, welche ebenfalls zum Aufrechterhalten oder Herstellen einer trockenen Packungsatmosphäre verwendet wird. Die Zusammensetzung wird aus der Schmelze, z.B. durch Extrusion oder Sprühen, in den Innenraum einer Verpackung appliziert, kann aber auch direkt auf das Füllgut aufgebracht werden. Bei direktem Aufbringen auf das Füllgut ist davon auszugehen, dass die Zusammensetzung aufgrund ihrer klebenden Eigenschaften auf jenem verbleibt. Jedenfalls bergen die klebenden Eigenschaften die Gefahr, dass das Füllgut beim Entfernen beschädigt wird.

US 6,936,131 beschreibt ein Verkapselungsverfahren für organische elektronische Aufbauten, bei dem ein Trockenmittel enthaltendes Transferklebeband zum Verbinden von Substrat und Abdeckung verwendet wird. Das Trockenmittel verzögert die Permeation von Wasserdampf durch die Verklebungsfuge zum elektronischen Aufbau. Das Klebeband verbleibt dauerhaft im Aufbau. Nachteilig ist, dass durch die enthaltenen Trockenmittel die Transparenz des Aufbaus beeinträchtigt wird.

Es ist also im Stand der Technik der Einsatz von Flächengebilden, oft in einer Ausführung als Klebeband, zum Trocknen von Gasräumen oder als Permeationsbarriere in Klebefugen bekannt. Darüber hinaus besteht jedoch auch Bedarf an Verfahren zum effizienten Trocknen von Flächengebilden, bei denen die eingesetzten Trockenvorrichtungen das Flächengebilde weder schädigen noch in seinen optischen Eigenschaften wesentlich verändern, aber dennoch durch flächigen Kontakt zueinander effizient trocknen.

Flächenförmige Gebilde, insbesondere solche, die in einem kontinuierlichen Prozess bahnförmig hergestellt oder verarbeitet werden, sind aufgrund ihrer oft großen Abmessungen sowie des häufigen Vorliegens in aufgewickelter Form als Rolle oder als Stapel schwer permeatfrei, insbesondere trocken, herzustellen oder von Permeat zu befreien. Aufgrund ihres großen Oberfläche/Volumen-Verhältnisses nehmen sie zudem leicht Permeat aus der Umgebung auf, müssen also vor dem Einbringen in eine permeatfreie Umgebung oder vor einem Kontakt mit permeatempfindlichen Materialien von diesem Permeat bzw. diesen Permeaten wieder befreit werden.

Aufgabe der Erfindung ist es daher, ein einfach durchzuführendes und wirksames Verfahren und eine geeignete Vorrichtung zur Aufnahme von Permeaten aus Flächengebilden, insbesondere solchen, die als Komponenten in organischen elektronischen Aufbauten verwendet werden und/oder solchen, die als Rolle oder Stapel vorliegen, zur Verfügung zu stellen.

Der Lösung der Aufgabe liegt der Gedanke zugrunde, dies über ein entsprechend ausgestattetes, Permeat aufnehmendes Flächengebilde zu realisieren.

Ein erster Gegenstand der Erfindung ist daher ein Verfahren zum Entfernen von Permeaten aus einem Flächengebilde I, das zumindest zum Teil im Aufbau einer organischen elektronischen Anordnung verwendet wird, welches das (unmittelbare oder mittelbare) flächige Inkontaktbringen des Flächengebildes I mit einem mindestens ein Gettermaterial enthaltenden und zur Aufnahme mindestens eines Permeats aus dem Flächengebilde I befähigten Flächengebilde II umfasst, wobei keine klebende Verbindung zwischen den Flächengebilden I und II zustande kommt.

Vorteilhaft ist, dass aufgrund des flächigen Kontakts zum zu trocknenden Flächengebilde I eine hohe Trocknungseffizienz erreicht wird sowie aufgrund der nicht klebenden Eigenschaften ein leichtes und beschädigungsfreies Entfernen des trocknenden Flächengebildes II ermöglicht wird.

"Unmittelbares Inkontaktbringen" bedeutet erfindungsgemäß, dass die Flächengebilde I und II in direkten Kontakt miteinander gelangen. "Mittelbares Inkontaktbringen" bedeutet, dass zwischen den Flächengebilden I und II weitere Schichten angeordnet sein können, die selbstverständlich hinreichend permeatdurchlässig sein müssen. Dabei soll das Permeat erfindungsgemäß jedoch nicht gezwungen sein, einen Gasraum zu durchwandern, um vom Flächengebilde I zum Flächengebilde II zu gelangen. Gasräume sind innerhalb von elektronischorganischen Aufbauten nachteilig, beispielsweise weil sie zu schlechterer Lichtauskopplung führen können. Bevorzugt werden das Flächengebilde I und das Flächengebilde II unmittelbar miteinander in Kontakt gebracht.

Bevorzugt verbleibt das Flächengebilde II nicht in der organischen elektronischen Anordnung. Insbesondere wird es vor dem Beginn der Verwendung des Flächengebildes I im Aufbau der organischen elektronischen Anordnung vom Flächengebilde I entfernt.

Dadurch, dass das Flächengebilde II nicht im Aufbau der organischen elektronischen Anordnung verbleibt, werden mögliche chemische Wechselwirkungen zwischen Gettermaterial und elektronisch aktiven Materialien vermieden. Auch der bei mit einem verbleibenden Getterpad versehenen organischen elektronischen Anordnungen nach dem Stand der Technik das Getterpad umgebende Gasraum wird vermieden, so dass bei optoelektronischen Anordnungen (z.B. bei Solarzellen oder OLEDs) eine höhere Lichtein- bzw. Lichtauskopplung erreicht wird, da weniger Grenzflächen mit hohem Brechungsindexunterschied im Lichtgang auftreten.

In einer bevorzugten Ausführung erfolgt das Inkontaktbringen der Flächengebilde derart, dass der Verbund aus von Permeat zu befreiendem Flächengebilde I und Permeat aufnehmendem Flächengebilde II in alternierender Schichtung vorliegt, also z.B. als Stapel oder als Rolle. Dies ermöglicht einen besonders intensiven Kontakt sowie, je nach Anordnung, auch eine zweiseitige Wirkung des Permeat aufnehmenden Flächengebildes sowie ein Abfangen von neu eindringendem Permeat aus der Umgebung.

Unter einem "Flächengebilde" wird eine flächenförmige Anordnung eines Systems verstanden, dessen Abmessungen in einer Raumrichtung (Dicke bzw. Höhe) signifikant kleiner sind als in den beiden anderen Raumrichtungen, die die Hauptausdehnung definieren (Länge und Breite). Ein derartiges Flächengebilde kann erfindungsgemäß kompakt oder auch durchbrochen ausgebildet sein und aus einem einzigen Material oder aus unterschiedlichen Materialien bestehen. Ein Flächengebilde kann eine über seine gesamte Flächenausdehnung konstante Dicke aufweisen oder aber unterschiedliche Dicken. Es kann darüber hinaus aus einer einzigen Schicht bestehen oder aus mehreren Schichten, die deckungsgleich oder zumindest teilweise nicht überdeckend angeordnet sein können.

Das von Permeat zu befreiende Flächengebilde I ist beispielsweise eine Folie, z.B. eine Polymerfolie, insbesondere eine Substrat-, Abdeck- oder Verklebungsfolie oder eine Trägerfolie, eine Dünnglasfolie, eine Metallfolie, ein Klebeband, eine Schicht, die auf einer Trägerfolie angeordnet und/oder Teil eines Schichtverbunds sein kann und die in einem (opto)elektronischen Aufbau Verwendung findet, z. B. eine Anodenschicht, eine Kathodenschicht, eine Loch- oder Elektronentransportschicht, eine Halbleiterschicht, insbesondere eine lichtemittierende Schicht, wie sie z.B. im LITI-Verfahren verwendet wird.

Unter einem Klebeband wird ein mit mindestens einem Haftklebstoff oder mindestens einem aktivierbaren Klebstoff beschichtetes Trägermaterial beziehungsweise ein als Flächengebilde vorliegender Haftklebstoff oder aktivierbarer Klebstoff von dauerhafter Gestalt verstanden. Ein Klebeband wird seiner Gestalt nach grundsätzlich als ein Flächengebilde angesehen. Bänder mit ausgedehnter Länge und begrenzter Breite, Bandabschnitte, Etiketten, Stanzlinge und dergleichen sind also von der Bezeichnung "Klebeband" mit umfasst. Nicht umfasst sind hingegen ausgehärtete und noch nicht ausgehärtete Flüssigklebstoffe beziehungsweise mit diesen hergestellte Verklebungen.

Erfindungsgemäß wird ein flächiger Kontakt bzw. die Verbindung zwischen den Flächengebilden I und II allgemein dann als nicht klebend angesehen, wenn er bzw. sie eine Klebkraft von < 0,5 N/cm, bevorzugt von < 0,05 N/cm aufweist. Ein flächiger Kontakt eines der Flächengebilde der Erfindung zu einer Haftklebemasse ist erfindungsgemäß immer als klebend anzusehen, auch wenn die Klebkraft im Einzelfall unterhalb der vorstehend definierten Klebkraft liegen sollte.

Bekannte Haftklebemassen sind beispielsweise solche auf der Basis von Acrylaten und/oder Methacrylaten, Polyurethanen, Naturkautschuken, Synthesekautschuken; Styrolblockcopolymermassen mit einem Elastomerblock aus ungesättigten oder hydrierten Polydienblöcken wie zum Beispiel Polybutadien, Polyisopren, Copolymeren aus beiden, Polybutylen, insbesondere Polyisobutylen, sowie weiteren, dem Fachmann geläufigen Elastomerblöcken; Polyolefinen, insbesondere Poly-α-olefinen und/oder Polyisobutylenen; Fluorpolymeren und/oder Silikonen. Unter den Begriff "Haftklebemasse" fallen auch weitere Massen, die haftklebende Eigenschaften entsprechend dem "Handbook of Pressure Sensitive Adhesive Technology" von Donatas Satas (Satas & Associates, Warwick 1999) besitzen.

Das im erfindungsgemäßen Verfahren eingesetzte Flächengebilde II enthält mindestens ein Gettermaterial. Dabei kann das Flächengebilde selbst vollständig aus dem Gettermaterial bestehen, eine Schicht aus dem Gettermaterial enthalten oder zumindest eine Schicht enthalten, die ein Gettermaterial enthält. Das Flächengebilde kann auch weitere Schichten enthalten, z.B. eine Trägerschicht, eine Kontaktschicht, eine Permeationsbarriereschicht oder spezifische Außenschichten.

Unter einem "Gettermaterial" wird dabei ein Stoff verstanden, der zur Aufnahme (Sorption) einer oder mehrerer permeationsfähiger Substanz(en) in der Lage ist. Die Sorption der permeationsfähigen Substanz(en) durch das Gettermaterial kann dabei beispielsweise durch Absorption oder Adsorption erfolgen, wobei Adsorption sowohl in Form von Chemisorption als auch von Physisorption auftreten kann. Das Gettermaterial ließe sich daher auch als "Sorbens" oder als "Sorptionsmittel" bezeichnen.

Unter einer "permeationsfähigen Substanz" wird eine Substanz verstanden, die als gasförmiger oder flüssiger, gegebenenfalls auch als fester Stoff, in das Flächengebilde eindringen und dieses nachfolgend durchdringen kann. Derartige Substanzen wurden vorstehend und werden nachstehend auch als "Permeate" bezeichnet. Die Permeate können aus dem Flächengebilde selbst oder aus der Umgebung stammen. Im Flächengebilde selbst enthalten sind häufig niedermolekulare organische Verbindungen wie Lösemittelreste, Restmonomere, Öle, Harzkomponenten, Weichmacher sowie Wasser. Aus der Umgebung stammen oft Wasser, flüchtige organische Verbindungen (VOCs), niedermolekulare Kohlenwasserstoffe und Sauerstoff. Als "permeationsfähige Substanzen" beziehungsweise "Permeate" werden insbesondere die folgenden Substanzen angesehen:

Acetonitril, 1-Butanol, Chlorbenzol, Chloroform (Trichlormethan), Cyclohexan, Diethylether, 1,4-Dioxan, Eisessig (Essigsäure), Essigsäureanhydrid, Essigsäureethylester (Ethylacetat, Essigester), Essigsäure-n-Butylester (n-Butylacetat), Essigsäure-tert.-butylester (t-Butylacetat), Ethanol, Methanol, n-Hexan, n-Heptan, 3-Hexanon, 2-Propanol (Isopropanol), 3-Methyl-1-butanol (Isoamylalkohol), Methylenchlorid (Dichlormethan), Methylethylketon (Butanon), Methylisobutylketon, Nitromethan (Nitrocarbol), n-Pentan, 2-Pentanon, 3-Pentanon, Petrolether (Leichtbenzin), Benzin, Propanol, Pyridin (Azin), tert-Butylmethylether, Tetrachlorethen (Perchlorethen), Tetrahydrofuran, Toluol, Trichlorethan, Triethylamin, Xylol, Sauerstoff, Methan, Ethan, Propan, Propen, Butan, Buten, Kohlenstoffdioxid, Ozon, Schwefeldioxid, Wasser.

Der Vorteil eines Gettermaterial enthaltenden Flächengebildes im Prozess der Permeatentfernung ist, dass das Gettermaterial das Permeat dem Gleichgewicht in der Matrix des Gettermaterial enthaltenden Flächengebildes entzieht und somit bessere Ergebnisse erreicht werden können.

Vorzugsweise kann im Rahmen des erfindungsgemäßen Verfahrens das Flächengebilde II zumindest Wasser zumindest zum Teil aus dem Flächengebilde I aufnehmen. Das erfindungsgemäße Verfahren ist somit insbesondere ein Verfahren zum Entfernen von Wasser aus einem Flächengebilde I, welches zumindest zum Teil im Aufbau einer organischen elektronischen Anordnung verwendet wird, umfassend:
das unmittelbare oder mittelbare flächige Inkontaktbringen des Flächengebildes I mit einem mindestens ein Gettermaterial enthaltenden und zur Aufnahme zumindest von Wasser aus dem Flächengebilde I befähigten Flächengebilde II, wobei keine klebende Verbindung zwischen den Flächengebilden I und II zustande kommt.

Geeignete Gettermaterialien sind beispielsweise: Salze wie Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Aluminiumsulfat, Calciumsulfat, Kupfersulfat, Bariumsulfat, Magnesiumsulfat, Lithiumsulfat, Natriumsulfat, Cobaltsulfat, Titansulfat, Natriumdithionit, Natriumcarbonat, Natriumsulfat, Kaliumdisulfit, Kaliumcarbonat, Magnesiumcarbonat; Schichtsilikate wie Montmorillonit und Bentonit; Metalloxide wie Bariumoxid, Calciumoxid, Eisenoxid, Magnesiumoxid, Natriumoxid, Kaliumoxid, Strontiumoxid, Aluminiumoxid (aktiviertes Alumina) und Titandioxid; weiter Kohlenstoffnanoröhrchen, Aktivkohle, Phosphorpentoxid und Silane; leicht oxidierbare Metalle wie beispielsweise Eisen, Calcium, Natrium und Magnesium; Metallhydride wie beispielsweise Calciumhydrid, Bariumhydrid, Strontiumhydrid, Natriumhydrid und Lithiumaluminiumhydrid; Hydroxide wie Kaliumhydroxid und Natriumhydroxid; Metallkomplexe wie zum Beispiel Aluminiumacetylacetonat; weiterhin Kieselsäuren wie zum Beispiel Silica-Gel; Kieselgur; Zeolithe; des Weiteren organische Absorber, beispielsweise Polyolefin-Copolymere, Polyamid-Copolymere, PET-Copolyester, Anhydride von einfachen und mehrfachen Carbonsäuren wie Essigsäureanhydrid, Propionsäureanhydrid, Buttersäureanhydrid oder Methyltetrahydrophthalsäureanhydrid oder weitere auf Hybridpolymeren basierte Absorber, die meist in Kombination mit Katalysatoren wie beispielsweise Cobalt verwendet werden; Carbodiimide; weitere organische Absorber wie etwa schwach vernetzte Polyacrylsäure, Polyvinylalkohol, Ascorbate, Glucose, Gallussäure oder ungesättigte Fette und Öle. Vorteilhaft eingesetzt, insbesondere für die Bindung von Sauerstoff, werden weiterhin metallorganische Oxidationsadditive auf der Basis chelatbildender Amine und Übergangsmetallkomplexe, insbesondere in Verbindung mit oxidierbaren Substratmaterialien.
Erfindungsgemäß können auch Mischungen aus zwei oder mehreren Gettermaterialien eingesetzt werden.

Die Gettermaterialien werden ihrer Funktion entsprechend bevorzugt als im Wesentlichen von Permeaten freie Materialien eingesetzt, zum Beispiel wasserfrei. Dies unterscheidet Gettermaterialien von ähnlichen Materialien, die als Füllstoff eingesetzt werden. So wird Silica zum Beispiel in Form von pyrogener Kieselsäure häufig als Füllstoff eingesetzt. Wird dieser Füllstoff jedoch wie üblich unter Umgebungsbedingungen gelagert, nimmt er bereits Wasser aus der Umgebung auf und ist nicht mehr in technisch nutzbarem Umfang als Gettermaterial funktionsfähig. Erst getrocknetes oder trocken gehaltenes Silica kann als Gettermaterial genutzt werden. Es ist erfindungsgemäß jedoch auch möglich, bereits teilweise mit Permeaten komplexierte Materialien zu verwenden, beispielsweise CaSO₄*1/2H₂O (Calciumsulfat-Halbhydrat) oder teilhydrierte Kieselsäuren, die per Definition als Verbindungen der allgemeinen Formel (SiO₂)ₘ*nH₂O vorliegen.

Unter "Silanen" werden Verbindungen der allgemeinen Formel Rₐ-Si-X₄₋ₐ oder deren partielle Kondensationsprodukte verstanden. In der Formel steht a für eine ganze Zahl von 0 bis 3 und bevorzugt für 0 oder 1. X steht für eine hydrolysierbare Gruppe, beispielsweise und bevorzugt für ein Halogen-Atom, insbesondere Chlor, eine Alkoxy-Gruppe wie beispielsweise eine Methoxy-, Ethoxy-, n-Propoxy-, iso-Propoxy-, n-Butoxy-, sec-Butoxy- oder tert-Butoxy-Gruppe oder für eine Acetoxy-Gruppe. Weitere, dem Fachmann bekannte Beispiele für hydrolysierbare Gruppen sind im Sinne der vorliegenden Erfindung ebenfalls einsetzbar. Sind mehrere Substituenten X vorhanden, so können diese gleich oder voneinander verschieden sein. R steht für einen gegebenenfalls substituierten Kohlenwasserstoffrest, beispielsweise für eine Methyl-, Ethyl-, n-Propyl-, iso-Propyl-, n-Butyl-, sec-Butyl-, tert-Butyl-Gruppe, eine Pentyl-Gruppe sowie deren verzweigte Isomere, eine Hexyl-Gruppen sowie die verzweigten Isomere, eine Heptyl-Gruppe sowie die verzweigten Isomere, eine Octyl-Gruppe sowie die verzweigten Isomere, eine Nonyl-Gruppe sowie die verzweigten Isomere, eine Decyl-Gruppe sowie die verzweigten Isomere, eine Undecyl-Gruppe sowie die verzweigten Isomere, eine Dodecyl-Gruppe sowie die verzweigten Isomere, eine Tetradecyl-Gruppe sowie die verzweigten Isomere, eine Hexadecyl-Gruppe sowie die verzweigten Isomere, eine Octadecyl-Gruppe sowie die verzweigten Isomere oder eine Eicosyl-Gruppe sowie die verzweigten Isomere. Die Kohlenwasserstoffreste können zudem ringförmige und/oder aromatische Bauteile enthalten. Repräsentative Strukturen dafür sind Cyclohexyl-, Phenyl- und Benzyl-Gruppen. Gegebenenfalls enthält/enthalten der/die Kohlenwasserstoffrest(e) R beispielsweise einen oder mehrere Heteroatom-haltige Substituenten wie Aminogruppen, Aminoalkylgruppen, Glycidyloxygruppen, (Meth)acryloxygruppen und dergleichen. Sind mehrere Substituenten R vorhanden, so können diese gleich oder voneinander verschieden sein.

Ein als Gettermaterial einsetzbares Silan ist bevorzugt ausgewählt aus der Gruppe umfassend N-(2-Aminoethyl)-3-aminopropyltrimethoxysilan, N-(2-Aminoethyl)-3-aminopropyltriethoxysilan, 3-Aminopropyltrimethoxysilan, 3-Aminopropyltriethoxysilan, 3-Aminopropyldiethoxymethylsilan, N-(2-Aminoethyl)-3-aminopropyldimethoxymethylsilan, (N-Butyl)-3-aminopropyltrimethoxysilan, 3-(N-Ethylamino)-2-methylpropyltrimethoxysilan, 4-Amino-3,3-dimethylbutyltrimethoxysilan, 4-Amino-3,3-dimethylbutyldimethoxymethylsilan, (N-Cyclohexyl)-aminomethyldimethoxymethylsilan, (N-Cyclohexyl)-aminomethyltrimethoxysilan, (N-Phenyl)-3-aminopropyltrimethoxysilan, (N-Phenyl)-aminomethyldimethoxymethylsilan, (N-Benzyl-2-aminoethyl)-3-aminopropyltrimethoxysilan, [2-(N-Benzyl-N-vinylamino)-ethyl]-3-aminopropyltrimethoxysilan Hydrogenchlorid, [2-(N-Benzyl-N-vinylamino)-ethyl]-3-aminopropyltrimethoxysilan, Bis-(3-propyltriethoxysilyl)-amin, Vinyltrimethoxysilan, Vinyltriethoxysilan, Vinyl-tri(2-methoxyethoxy)-silan, Vinyltriisopropoxysilan, Vinyldimethoxymethylsilan, Vinyltriacetoxysilan, 3-Triethoxysilylpropylbernsteinsäureanhydrid, 3-Glycidyloxypropyltrimethoxysilan, 3-Glycidyloxypropyltriethoxysilan, 2-(3,4-Epoxycyclohexyl)-ethyltriethoxysilan, 3-Glycidyloxypropyldiethoxymethylsilan, 3-Methacryloyloxypropyltrimethoxysilan, 3-Methacryloyloxypropyltriethoxysilan, 3-Methacryloyloxypropyltriisopropoxysilan, 3-Methacryloyloxypropyldimethoxymethylsilan, 3-Methacryloyloxypropyldiethoxymethylsilan, 3-Chloropropyltrimethoxysilan, 3-Chloropropyltriethoxysilan, 3-Isocyanatopropyltrimethoxysilan, 3-Isocyanatopropyltriethoxysilan, Isocyanatomethyltrimethoxysilan, Isocyanatomethyldimethoxymethylsilan, Tris-[3-(trimethoxysilyl)-propyl]-isocyanurat, 3-Ureidopropyltrimethoxysilan, 3-Ureidopropyltriethoxysilan, 2-Hydroxy-4-(3-triethoxysilylpropoxy)-benzophenon, 4-(3'-Chlorodimethylsilylpropoxy)-benzophenon, 3-Mercaptopropyltrimethoxysilan, 3-Mercaptopropyldimethoxymethylsilan, Bis-(3-triethoxysilylpropyl)-disulfan, Bis-(3-triethoxysilylpropyl)-tetrasulfan, Bis-(triethoxysilylpropyl)-polysulfan und Octadecylaminodimethyltrimethoxysilylpropylammoniumchlorid.

Bevorzugt ist das Gettermaterial ausgewählt aus der Gruppe bestehend aus Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Aluminiumsulfat, Calciumsulfat, Kupfersulfat, Bariumsulfat, Magnesiumsulfat, Lithiumsulfat, Natriumsulfat, Cobaltsulfat, Titansulfat, Natriumcarbonat, Natriumsulfat, Kaliumcarbonat, Magnesiumcarbonat sowie
Kieselgur, Kieselsäuren (Silica), Zeolithen, Schichtsilikaten sowie
Eisen, Calcium, Barium, Natrium, Magnesium, Bariumoxid, Calciumoxid, Eisenoxid, Magnesiumoxid, Natriumoxid, Titandioxid, Kaliumoxid, Strontiumoxid, aktiviertem Aluminiumoxid sowie
Kohlenstoffnanoröhrchen, Aktivkohle, Phosphorpentoxid, Silanen sowie
Calciumhydrid, Bariumhydrid, Strontiumhydrid, Natriumhydrid, Lithiumaluminiumhydrid, Kaliumhydroxid, Natriumhydroxid sowie Aluminiumacetylacetonat sowie
Essigsäureanhydrid, Propionsäureanhydrid, Buttersäureanhydrid, Methyltetrahydrophthalsäureanhydrid, Polyacrylsäure und Polyvinylalkohol, da diese Materialien sich insbesondere gut als Wassergetter eignen.

Unter dem Aspekt einer besonders ausgeprägten Bindungswirkung gegenüber Sauerstoff ist das Gettermaterial bevorzugt ausgewählt aus der Gruppe bestehend aus Eisen, Natriumdithionit, Bariumoxid, Eisen(II,III)-Oxid, Carbohydrazid, aktiviertem Aluminiumoxid, Zeolithen, Aktivkohle, Sulfiten, Ascorbaten, Hydrazin, Morpholin, 2-Butanonoxim, Diethylhydroxylamin, Glucose, Gallussäure, ungesättigten Fetten und Ölen sowie metallorganischen Oxidationsadditiven auf der Basis chelatbildender Amine und Übergangsmetallkomplexe, insbesondere in Verbindung mit oxidierbaren Substratmaterialien.

Besonders bevorzugt ist das Gettermaterial ausgewählt aus der Gruppe bestehend aus Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Aluminiumsulfat, Calciumsulfat, Kupfersulfat, Bariumsulfat, Magnesiumsulfat, Lithiumsulfat, Natriumsulfat, Cobaltsulfat, Titansulfat, Natriumcarbonat, Natriumsulfat, Kaliumcarbonat, Zeolithen, Calcium, Magnesium, Bariumoxid, Calciumoxid, Magnesiumoxid, Natriumoxid, Kaliumoxid, Strontiumoxid, Aktivkohle, Phosphorpentoxid, Silanen, Calciumhydrid, Bariumhydrid, Strontiumhydrid, Natriumhydrid und Lithiumaluminiumhydrid, Kaliumhydroxid, Natriumhydroxid, Essigsäureanhydrid, Propionsäureanhydrid, Buttersäureanhydrid, Methyltetrahydrophthalsäureanhydrid und Carbodiimiden sowie Mischungen von zwei oder mehreren der vorstehenden Substanzen. Diese Materialien weisen eine hohe Sorptionskapazität gegenüber mindestens einem der oben genannten Permeate und insbesondere auch gegenüber Wasser auf.

Unter "Carbodiimiden" werden Verbindungen der allgemeinen Formel R¹-N=C=N-R² verstanden, wobei R¹ und R² organische Reste, insbesondere Alkyl- oder Arylreste sind, die gleich oder verschieden sein können.

Ganz besonders bevorzugt ist das Gettermaterial ausgewählt aus der Gruppe bestehend aus Barium, Calcium, Calciumsulfat, Calciumchlorid, Calciumoxid, Natriumsulfat, Kaliumcarbonat, Kupfersulfat, Magnesiumperchlorat, Magnesiumsulfat, Lithiumchlorid, Kieselsäuren und Zeolithen sowie Mischungen von zwei oder mehreren der vorstehenden Substanzen. Diese Gettermaterialien bieten den Vorteil, dass sie sich leicht in die betreffende Schicht des Klebebands einarbeiten lassen, ein hohes Sorptionsvermögen zeigen und regenerierbare Gettermaterialien sind. Darunter werden Substanzen verstanden, die aufgenommene Permeate, beispielsweise Wasser, unter bestimmten Bedingungen wieder abgeben können und dadurch in einen Zustand gelangen, der sie zu erneuter Permeataufnahme befähigt. Dies ermöglicht ein Verfahren, bei dem das Getter-haltige Flächengebilde vor dem Inkontaktbringen mit dem von Permeaten zu befreienden Flächengebilde von gegebenenfalls bis zu diesem Zeitpunkt aufgenommenen Permeaten weitgehend befreit wird, beispielsweise durch Erhitzen. Dadurch steht vorteilhaft bei Verwendung des Getter-haltigen Flächengebildes die volle Getterkapazität zur Verfügung.

Insbesondere ist das Gettermaterial ausgewählt aus der Gruppe bestehend aus Calciumoxid, Calciumsulfat, Calciumchlorid, pyrogenen Kieselsäuren und Zeolithen sowie Mischungen von zwei oder mehreren der vorstehenden Substanzen. Diese Materialien weisen besonders hohe Kapazitäten für die Aufnahme von Wasser und weiteren Permeaten auf, sind größtenteils regenerierbar und lassen sich hervorragend in das Flächengebilde einarbeiten.

In einer besonderen Ausführungsform der Erfindung ist das Gettermaterial ausgewählt aus Calciumoxid, Calcium, Eisen, Barium, Lithiumchlorid und Cobaltchlorid. Diese Substanzen lassen über eine Änderung ihrer optischen Eigenschaften Rückschlüsse auf den Permeatgehalt des Flächengebildes zu. So lange also noch freie Getterkapazität anhand des optischen Erscheinungsbildes des Flächengebildes erkennbar ist, kann dies als Indiz dafür gelten, dass noch kein oder allenfalls wenig Permeat in das zu schützende Flächengebilde diffundiert ist. Metallisches Calcium beispielsweise verliert seine metallisch-undurchsichtige Erscheinung und wird zunehmend transparent; Cobaltchlorid ändert seine Farbe bei Wasseraufnahme von blau zu rosa. Insbesondere ist das Gettermaterial Calciumoxid.

Vorteilhaft beträgt der Anteil des Gettermaterials in der das Gettermaterial enthaltenden Schicht des Flächengebildes II jeweils mindestens 1 Gew.-%, bevorzugt mindestens 10 Gew.-%, jeweils bezogen auf das Gewicht der betreffenden Schicht. Der maximale Anteil des Gettermaterials in der das Gettermaterial enthaltenden Schicht des Flächengebildes II ist jeweils nicht begrenzt und kann bis zu einer Schicht aus reinem Gettermaterial reichen.

Der Gehalt hängt wesentlich von der gewünschten Aufnahmekapazität des Flächengebildes II für das/die jeweiligen Permeat(e) ab.

Wenn zum Beispiel nur eine geringe Aufnahmekapazität erforderlich ist, reicht gegebenenfalls die Verwendung eines Gettermaterials mit geringer Aufnahmekapazität in einem geringen Gehalt aus. In einer bevorzugten Ausführungsform enthält die das Gettermaterial enthaltende Schicht bzw. enthalten die das Gettermaterial enthaltenden Schichten des Flächengebildes II daher jeweils 1 bis 5 Gew.-% Gettermaterial, jeweils bezogen auf das Gesamtgewicht der betreffenden Schicht.

Bei einer sehr hohen erforderlichen Aufnahmekapazität des Flächengebildes II muss jedoch ein relativ hoher Gehalt an Gettermaterial in der das Gettermaterial enthaltenden Schicht verwendet werden, wobei auch das Gettermaterial eine hohe Aufnahmekapazität besitzen sollte. Aber auch ein Gettermaterial mit geringer Aufnahmekapazität kann verwendet werden, wenn dies Kosten- oder Verträglichkeitsaspekte anraten. Im Rahmen einer weiteren bevorzugten Ausführungsform des erfindungsgemäßen Verfahrens enthält die das Gettermaterial enthaltende Schicht bzw. enthalten die das Gettermaterial enthaltenden Schichten des Flächengebildes II daher 20 bis 99 Gew.-% Gettermaterial, bezogen auf das Gesamtgewicht der betreffenden Schicht.

Handelt es sich bei der das Gettermaterial enthaltenden Schicht um eine Klebemasse, so ist ein Gehalt von 10 bis 80 Gew.-%, bezogen auf das Gewicht der das Gettermaterial enthaltenden Schicht, bevorzugt, damit ausreichende Klebeigenschaften erhalten bleiben.

Bevorzugt weist das Gettermaterial enthaltende Flächengebilde II selbst vor der Applikation einen Permeatgehalt von weniger als 1000 ppm, besonders bevorzugt von weniger als 100 ppm auf. Die Angabe ppm bezieht sich dabei auf die Relation des enthaltenen Gesamtgewichts an Permeaten zum Gewicht des Flächengebildes. Der Permeatgehalt kann mittels der Gaschromatographie nach VDA 277 bestimmt werden oder im Fall von Wasser nach DIN 53715 (Karl-Fischer-Titration) nach Lagerung des Prüflings über 24 Stunden bei 23°C und 50 % relativer Luftfeuchte. Bei geringen Permeatgehalten wird die Kapazität der Gettermaterialien des Flächengebildes II nicht so stark durch aus dem Flächengebilde selbst diffundierende Permeate beansprucht, und das Flächengebilde kann seine Funktion als Permeatentfernungsvorrichtung besser erfüllen.

Besonders vorteilhaft weist zumindest eine der nach dem Inkontaktbringen des Flächengebildes II mit dem Flächengebilde I auf der dem Flächengebilde I abgewandten Seite der Gettermaterial-haltigen Schicht angeordnete Schicht des Flächengebildes II, besonders bevorzugt mindestens eine der äußeren Schichten des Flächengebildes II, z.B. eine außenliegende, nicht klebende Polymerschicht, eine geringe Permeationsrate für das zu immobilisierende Permeat auf. Im Fall von Wasserdampf als Permeat beträgt die Wasserdampfpermeationsrate (WVTR) bevorzugt weniger als 50 g/(m²*d), besonders bevorzugt weniger als 20 g/(m²*d), bezogen auf eine Schichtdicke von 50 µm. Die WVTR wird dabei bei 38°C und 90% relativer Luftfeuchtigkeit nach ASTM F-1249, die Sauerstoffpermeationsrate (OTR) bei 23°C und 50% relativer Luftfeuchtigkeit nach DIN 53380-Teil 3 gemessen.

Durch die geringe Permeationsrate diffundiert insbesondere bei der Herstellung des Flächengebildes weniger Permeat aus der Umgebung durch die betreffende(n) Schicht(en) hindurch in die gettermaterialhaltige Schicht bzw. durch das Matrixmaterial der gettermaterialhaltigen Schicht zum Gettermaterial das somit seine Funktion länger erfüllen oder in einer noch geringeren Menge eingesetzt werden kann, was Kosten spart. Besonders bevorzugt weist daher zumindest das Matrixmaterial der Gettermaterial enthaltenden Schicht des Flächengebildes II eine geringe Permeationsrate für das zu immobilisierende Permeat auf.

Bevorzugt werden aufgrund der in der Regel relativ geringen Wasserdampfpermeationsrate Schicht- bzw. Matrixmaterialien auf der Basis von Synthesekautschuken eingesetzt, insbesondere auf der Basis von Polyisobutylen und dessen Copolymeren, Polybuten, Butylkautschuk; Styrolblockcopolymeren mit Polymerblöcken gebildet durch Polymerisation von 1,3-Dienen, insbesondere von Butadien, Isobutylen und/oder Isopren, welche auch spezifisch oder vollständig hydrierte Polymerblöcke enthalten können; sowie Polyolefinen und deren Copolymeren, Polyvinylchlorid (PVC), insbesondere Hart-PVC, Polyvinylidenchlorid (PVDC), Polyacetalen, Fluorpolymeren sowie Polyethylen-Vinylalkohol (EVOH)..

Besonders bevorzugt ist das Matrixmaterial der Gettermaterial enthaltenden Schicht und/oder das Material der für den Kontakt mit dem zu trocknenden Flächengebilde I vorgesehenen Außenschicht des Flächengebildes II ein Elastomer, da durch die Elastizität ein verbesserter Kontakt zum von Permeat zu befreienden Flächengebilde I hergestellt werden und somit die Wirksamkeit verbessert werden kann, ohne jedoch klebende Eigenschaften aufzuweisen.

In einer Ausführungsform der Erfindung weist das Gettermaterial enthaltende Flächengebilde II ein Trägermaterial auf, da hierdurch vorteilhaft die Stanzbarkeit und/oder Applizierbarkeit verbessert wird.

Als Trägermaterial können textile Flächengebilde, Papiere, kunststoffbeschichtete Papiere oder Folien eingesetzt werden, wobei Folien, insbesondere dimensionsstabile Kunststoff- oder Metallfolien, bevorzugt werden. Die Trägerschicht bzw. das Trägermaterial besteht daher bevorzugt aus Polyestern, insbesondere aus Polyethylenterephthalat, zum Beispiel aus biaxial verstrecktem Polyethylenterephthalat; oder aus Polyolefinen, insbesondere aus Polybuten, Cyclo-Olefin-Copolymer, Polymethylpenten, Polypropylen oder Polyethylen, zum Beispiel aus monoaxial verstrecktem Polypropylen, biaxial verstrecktem Polypropylen oder biaxial verstrecktem Polyethylen. Polyesterfolien weisen den Vorteil auf, dass sie für Temperaturstabilität sorgen und eine erhöhte mechanische Stabilität einbringen. Ganz besonders bevorzugt besteht daher die Trägerschicht bzw. das Trägermaterial des im erfindungsgemäßen Verfahren eingesetzten Gettermaterial enthaltenden Flächengebildes II aus einer Polyesterfolie, beispielsweise aus biaxial verstrecktem Polyethylenterephthalat.

In einer bevorzugten Ausführungsform enthält das Trägermaterial auch eine Barrierefunktion gegen ein oder mehrere spezifische(s) Permeat(e), insbesondere gegen Wasserdampf und Sauerstoff, damit das im Flächengebilde II befindliche Gettermaterial nicht schon während der Herstellung und/oder Lagerung des Flächengebildes durch aus der Umgebung eindiffundierendes Permeat teilweise oder sogar vollständig abgesättigt wird. Eine derartige Barrierefunktion kann aus organischen oder anorganischen Materialien bestehen..

Besonders bevorzugt enthält das Trägermaterial mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle, wie Aluminium, Silber, Gold, Nickel oder insbesondere Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Als besonders geeignetes Verfahren zum Aufbringen einer anorganischen Barriereschicht sind High-Power-Impulse-Magnetron-Sputtering und Atomic-Layer-Deposition zu nennen, durch die sich besonders permeationsdichte Schichten bei geringer Temperaturbelastung der Trägerschicht verwirklichen lassen. Bevorzugt wird eine Permeationsbarriere der Trägerschicht mit Barrierefunktion beziehungsweise des Verbundes aus Trägerschicht und Barriereschicht gegen Wasserdampf (WVTR) von < 1 g/(m²*d) und/oder gegen Sauerstoff (OTR) von < 1 cm³/(m²*d*bar), wobei der Wert auf die jeweils im Flächengebilde verwendete Dicke der Trägerschicht bezogen ist, also nicht auf eine spezifische Dicke normiert ist. Die WVTR wird dabei bei 38°C und 90% relativer Luftfeuchtigkeit nach ASTM F-1249 und die OTR bei 23°C und 50% relativer Luftfeuchtigkeit nach DIN 53380-Teil 3 gemessen.

Die Dicke des im erfindungsgemäßen Verfahren eingesetzten Flächengebildes II kann alle üblichen Dicken umfassen, also etwa von 1 µm bis zu 3000 µm. Bevorzugt wird eine Dicke zwischen 25 und 100 µm, da in diesem Bereich Flexibilität und Handlingeigenschaften besonders positiv ausfallen. Ein weiterer bevorzugter Bereich ist eine Dicke von 3 bis 25 µm, da in diesem Bereich die Gesamtdicke aus den Flächengebilden I und II nicht sehr erhöht wird und somit z.B. mehr Material auf eine Rolle mit definiertem Durchmesser aufgewickelt werden kann.

Zur Herstellung eines im erfindungsgemäßen Verfahren einsetzbaren Flächengebildes II wird bevorzugt der Träger des Flächengebildes oder ein temporäres Trägermaterial (Liner) einseitig mit einer gettermaterialhaltigen Matrixmasse aus Lösung oder Dispersion oder 100 %ig (zum Beispiel Schmelze) beschichtet oder bedruckt, oder das Flächengebilde wird durch (Co-)Extrusion hergestellt. Alternativ ist eine Herstellung durch Transfer einer bevorzugt gettermaterialhaltigen Klebemasseschicht durch Kaschieren auf ein Trägermaterial möglich.

Die Schicht, welche das Gettermaterial enthält, kann grundsätzlich direkt mittels dem Fachmann bekannter Verfahren aus der Lösung, Emulsion oder Dispersion aufgebracht werden. Das verwendete Löse-, Emulsions- beziehungsweise Dispergiermittel kann in diesem Fall anschließend in einem handelsüblichen Trockner verdampft werden. Ebenso ist eine lösungsmittelfreie Beschichtung, z.B. mittels Streu, Beflockungs- oder Bepuderungsverfahren, geeignet.

Die Schicht, welche das Gettermaterial enthält, kann erfindungsgemäß auch gedruckt werden. Hierzu eignen sich nach dem Stand der Technik Tief- und Siebdruckverfahren. Bevorzugt werden hier rotative Druckverfahren angewendet. Ferner können Beschichtungen auch durch Aufsprühen aufgebracht werden. Dies kann im rotativen Sprühverfahren geschehen, gegebenenfalls auch elektrostatisch.

Bevorzugt findet dieser Herstellprozess in einer Umgebung statt, in der das spezifische Permeat nur in geringer Konzentration oder nahezu gar nicht enthalten ist. Als Beispiel kann eine relative Luftfeuchtigkeit von weniger als 30 %, bevorzugt von weniger als 15 %, genannt werden.

Zur Optimierung der Eigenschaften können die zum Einsatz kommenden Schichtmaterialien mit einem oder mehreren Additiven wie Weichmachern, Füllstoffen, Pigmenten, UV-Absorbern, Lichtschutzmitteln, Alterungsschutzmitteln, Vernetzungsmitteln und/oder Vernetzungspromotoren abgemischt sein.

Die Menge bzw. das Auftragsgewicht einer Gettermaterial enthaltenden Schicht im Flächengebilde II beträgt bevorzugt 1 bis 200 g/m², vorzugsweise 10 bis 100 g/m², wobei unter "Menge" die Menge nach einer eventuell durchgeführten Entfernung von Wasser oder Lösungsmittel verstanden wird.

Bevorzugten Einsatz findet das erfindungsgemäße Verfahren beim Entfernen von Permeaten aus Einsatzmaterialien und/oder Zwischenprodukten in der Fertigung von organischen elektronischen Aufbauten; insbesondere aus Substrat-, Verklebungs- oder Abdeckmaterialien, aus insbesondere gedruckten Anoden oder Kathoden, insbesondere gedruckten leitfähigen Schichten oder Leiterbahnen, Lochinjektionsschichten (Hole-injection-layers (HIL) oder Elektronentransportschichten (ETL), insbesondere solchen auf der Basis wässriger Dispersionen von intrinsisch leitfähigen Polymeren wie z.B. PEDOT:PSS, sowie aus insbesondere gedruckten organischen lichtemittierenden oder -absorbierenden Schichten, insbesondere LITI-Folien; darüber hinaus aus Wirkstoffpflastern, medizinischen, biologischen oder chemischen Testaufbauten, insbesondere Teststreifen, sowie aus Einsatzmaterialien oder Zwischenprodukten in der Fertigung elektrochemischer Zellen, wie z.B. Brennstoffzellen oder Elektrolysezellen.

Besonders bevorzugt wird das erfindungsgemäße Verfahren zum Entfernen von Permeaten aus Substrat-, Verklebungs- oder Abdeckfolien, aus Lochinjektions- und Transportschichten, Elektronentransportschichten sowie aus organischen lichtemittierenden oder -absorbierenden Schichten eingesetzt.

Ein weiterer Gegenstand der Erfindung ist ein Flächengebilde, das eine nicht klebende, elastomere Kontaktschicht sowie mindestens eine weitere, mindestens ein Gettermaterial enthaltende und zur Aufnahme mindestens eines Permeats durch die elastomere Kontaktschicht hindurch befähigte Schicht umfasst, wobei die elastomere Kontaktschicht bei Raumtemperatur einen geringeren Elastizitätsmodul aufweist als zumindest eine weitere im Aufbau des Flächengebildes enthaltene Schicht, z.B. die Trägerschicht, insbesondere als die weitere, mindestens ein Gettermaterial enthaltende Schicht, wobei ferner das Gettermaterial als dispergierte Phase in einem Matrixmaterial enthalten und das Matrixmaterial eine Haftklebemasse ist. Die Bestimmung des Elastizitätsmoduls erfolgt nach DIN-EN-ISO 527-3 bei 23°C und 50 % relativer Luftfeuchte mit Probekörper Typ 2 bei einer Prüfgeschwindigkeit von 50 mm/min.

Die Kontaktschicht ist für den Kontakt mit dem von Permeat zu befreienden Flächengebilde vorgesehen. Dadurch, dass die elastomere Kontaktschicht einen geringeren Elastizitätsmodul aufweist als zumindest eine weitere im Aufbau des Flächengebildes enthaltene Schicht, übernimmt sie keine Trägerfunktion und kann somit vorteilhaft auf einen guten Kontakt ausgelegt werden. Vorteilhaft an dieser Ausführung ist der gute Kontakt durch die elastomere Kontaktschicht (Außenschicht) und die Vermeidung eines direkten Kontakts von Gettermaterial und von Permeat zu befreiendem Flächengebilde. Aufgrund der Reaktivität der Gettermaterialien könnte es anderenfalls zu unerwünschten chemischen Interaktionen oder aufgrund der Härte einiger Gettermaterialien zu mechanischen Beeinträchtigungen kommen.

Bereits im Rahmen der Beschreibung des erfindungsgemäßen Verfahrens offenbarte Ausführungsformen des dort eingesetzten, Gettermaterial enthaltenden Flächengebildes II gelten selbstverständlich auch für das erfindungsgemäße Flächengebilde, sofern sie zu diesem nicht in Widerspruch stehen. Andersherum stellen Ausführungsformen des erfindungsgemäßen Gettermaterial enthaltenden Flächengebildes gleichzeitig auch mögliche Ausführungsformen im erfindungsgemäßen Verfahren einsetzbarer Flächengebilde II dar.

Das Gettermaterial ist in einem Matrixmaterial als dispergierte Phase enthalten. Unter "als dispergierte Phase enthalten" wird verstanden, dass das Gettermaterial fein verteilt in der/den betreffenden Schicht(en) des Matrixmaterials vorliegt. Grundsätzlich sind Form und Größe der Gettermaterial-Teilchen - selbstverständlich innerhalb der sich aus dem Aufbau und der Funktion des Flächengebildes bzw. der Schichten ergebenden Limitierungen - keine Grenzen gesetzt. Das Merkmal "als dispergierte Phase enthalten" schließt eine molare Dispersion und damit eine echte (molekulare) Lösung des Gettermaterials in dem Material der betreffenden Schicht ebenso ein wie eine Dispersion von Gettermaterial-Primärteilchen, Gettermaterial-Aggregaten und Gettermaterial-Agglomeraten.

Das Merkmal "als dispergierte Phase enthalten" bedeutet darüber hinaus, dass das betreffende Gettermaterial keine eigenständige, durchgehende Schicht bildet, sondern generell in Form mehrerer, verteilter Teilchen vorliegt. Es bedeutet hingegen nicht, dass eine ideale oder statistische Verteilung der Gettermaterial-Teilchen im Schichtmaterial vorliegen muss. Die Gettermaterial-Teilchen können sich zum Beispiel durchaus in bestimmten Bereichen innerhalb der Schicht konzentrieren bzw. können bestimmte Bereiche einer Getter-haltigen Schicht auch frei von Gettermaterial sein.

Die Verteilung des Gettermaterials als dispergierte Phase in einer Schicht des erfindungsgemäßen Flächengebildes weist gegenüber einer durchgehenden, eigenständigen Gettermaterial-Schicht den Vorteil auf, dass die spezifische Oberfläche zur Aufnahme von Permeaten größer ist als im Falle einer durchgehenden Schicht und somit höhere Aufnahmekapazitäten für Permeate realisiert werden können.

Grundsätzlich ist die Größe der Partikel des Gettermaterials durch die Anforderungen der Dicke der diese jeweils enthaltenden Schicht begrenzt. Als eine obere Grenze für die Größe der Partikel können daher etwa 200 µm angesehen werden, bevorzugt wird aber Gettermaterial in Form von Teilchen mit einer Korngröße von maximal 50 µm verwendet.

Im erfindungsgemäßen, Gettermaterial enthaltenden Flächengebilde können durchaus mehrere Schichten, beispielsweise eine Trägerschicht und gegebenenfalls auch noch weitere Schichten das gleiche oder auch verschiedene Gettermaterial(ien) enthalten.

Vorzugsweise liegt das Gettermaterial in Form von Partikeln in einer Partikelgrößenverteilung vor, bei der maximal 1 Vol.-% des Gettermaterials die mittlere Schichtdicke der gettermaterialhaltigen Schicht überschreitet. Dies hat den Vorteil, dass die Getterpartikel nicht aus der jeweiligen Schicht herausragen und damit die Oberflächeneigenschaften stark negativ beeinflussen. In einer besonders bevorzugten Ausführungsform liegt das gesamte im erfindungsgemäßen Flächengebilde enthaltene Gettermaterial in einer Partikelgrößenverteilung vor, bei der maximal 1 Vol.-% des Gettermaterials die mittlere Schichtdicke der jeweiligen gettermaterialhaltigen Schicht überschreitet.

In einer alternativen bevorzugten Variante liegt das Gettermaterial in Form von Partikeln in einer Partikelgrößenverteilung vor, bei der zumindest 10 Vol.-% die mittlere Schichtdicke der gettermaterialhaltigen Schicht überschreiten. Dies führt zu einer rauen Oberfläche und kann die Verankerung der verschiedenen Schichten im Schichtverbund des Flächengebildes verbessern. Besonders bevorzugt liegt das gesamte im erfindungsgemäßen Flächengebilde enthaltene Gettermaterial in einer Partikelgrößenverteilung vor, bei der zumindest 10 Vol.-% die mittlere Schichtdicke der jeweiligen gettermaterialhaltigen Schicht überschreiten.

Unter "Partikeln" werden im Sinne von DIN 53206-1: 1972-08 Primärteilchen, Aggregate und Agglomerate des Gettermaterials beziehungsweise der Gettermaterialien verstanden. Unter der "Partikelgröße" wird die maximale Ausdehnung eines Partikels verstanden. Die Bestimmung der Partikelgröße erfolgt bevorzugt mittels Laserbeugung nach ISO 13320 (wobei im Dispersionsschritt Agglomerate dispergiert werden, nicht jedoch Aggregate), aber auch andere dem Fachmann bekannte Verfahren sind geeignet.

Besonders bevorzugt liegen alle Gettermaterialien nanoskalig vor, das heißt die maximale Ausdehnung in mindestens einer Dimension beträgt weniger als 500 nm, ganz besonders bevorzugt weniger als 200 nm, beispielsweise weniger als 100 nm.

Solche Gettermaterialien können beispielsweise dispergiertes pyrogenes Silica wie Aerosil der Firma Evonik, Calcium Oxide Nanopowder der Firma Sigma-Aldrich, Calciumchlorid CA-Cl-02-NP der Firma American Elements (Los Angeles), Nanozeolith LTA oder FAU der Firma Nanoscape (Planegg-Martinsried) oder nanoskaliges Zeolith Lucidot NCL 40 der Firma Clariant (Frankfurt) sein.

Das Matrixmaterial ist eine Haftklebemasse, insbesondere eine Haftklebemasse mit inhärenter Barrierewirkung. Als solche Haftklebemassen, die bei einer Dicke von 50 µm eine Wasserdampfpermeationsrate von weniger als 50 g/(m²*d) und/oder eine Sauerstoffdurchtrittsrate von weniger als 5000 g/(m²*d*bar) aufweisen, lassen sich beispielweise solche Klebemassen einsetzen, wie sie in den Schriften DE 102010043871 (A1), DE 102010043866 (A1), DE 102008060113 A1, DE 200810062130 A1, DE 200810047964 A1, DE 200910036970 A1, DE 200910036968 A1, US 20090026934 (A1), EP 1 469 054 B1 und EP 0519278 B2 offenbart werden.

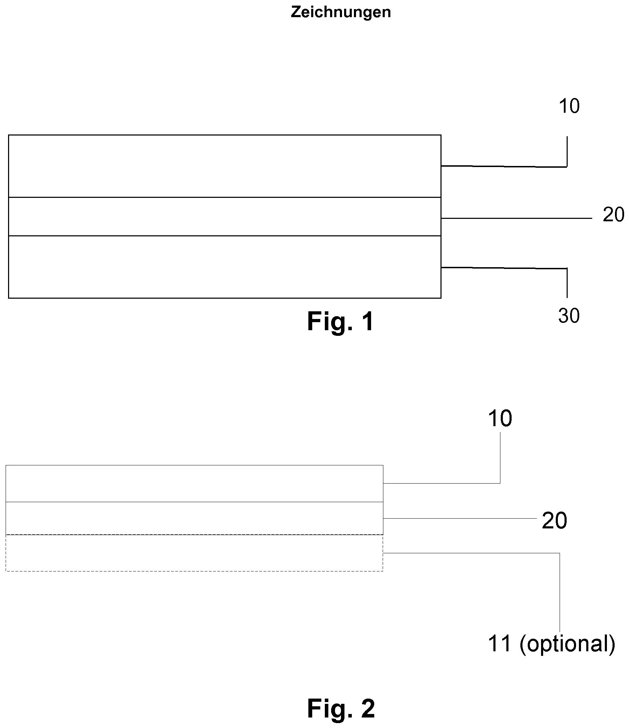

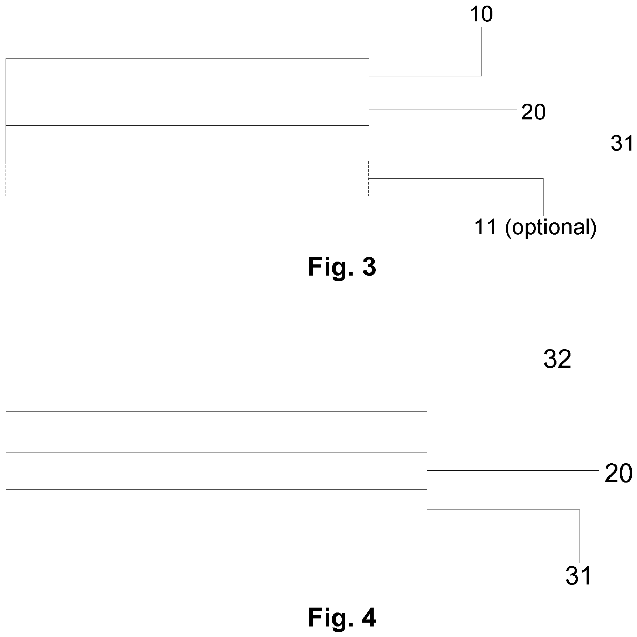

Mögliche Ausführungsformen eines erfindungsgemäßen, Gettermaterial enthaltenden Flächengebildes sind in den Figuren 1 bis 4 dargestellt. Darin bedeuten:
Fig. 1:
   10: nicht klebende elastomere Kontaktschicht
   20: Schicht enthaltend Gettermaterial
   30: Trägermaterial mit WVTR < 1 g/m²d bei 38°C und 90 % rF bezogen auf die eingesetzte Trägermaterialdicke
Fig. 2:
   10: nicht klebende elastomere Kontaktschicht.
   20: Schicht enthaltend Gettermaterial
   11: optional weitere nicht klebende Kontaktschicht
Fig. 3:
   10: nicht klebende elastomere Kontaktschicht
   20: Schicht enthaltend Gettermaterial
   31: Trägermaterial
   11: optional: weitere nicht klebende elastomere Kontaktschicht
Fig. 4
   32: Trägermaterial
   20: Schicht enthaltend Gettermaterial
   31: Trägermaterial

Ein weiterer Gegenstand der Erfindung ist die Verwendung eines erfindungsgemäßen Flächengebildes zum Entfernen von Permeaten aus einem Flächengebilde, bevorzugt zum zumindest teilweisen Entfernen von zumindest Wasser aus einem Flächengebilde.

### Beispielteil

Es wurden verschiedene Gettermaterial enthaltende Flächengebilde zur Durchführung des Verfahrens hergestellt.

### Nichtklebende Elastomerschichten und Klebemassen:

Zur Herstellung von Schichten wurden verschiedene Materialien aus einer Lösung auf einen konventionellen Liner des Typs Silphan S75 M371 der Firma Siliconature mittels eines Laborstreichgeräts aufgebracht und getrocknet. Die Schichtdicke nach dem Trocknen betrug jeweils 50 µm. Die Trocknung erfolgte jeweils bei 120 °C über 30 min in einem Labortrockenschrank.

**M1 Haftklebemasse**

| | | |
|---|---|---|
| 100 Teile | Tuftec P 1500 | SBBS mit 30 Gew.-% Blockpolystyrolgehalt der Firma Asahi. Das SBBS enthält ca. 68 Gew.-% Zweiblockgehalt. |
| 100 Teile | Escorez 5600 | Hydriertes KW-Harz mit einem Erweichungspunkt von 100 °C der Firma Exxon |
| 25 Teile | Ondina 917 | Weißöl aus paraffinischen und naphthenischen Anteilen der Firma Shell |

Als Lösungsmittel wurde ein Gemisch aus Toluol und Aceton im Verhältnis 2:1 verwendet.

**M2: nichtklebendes Elastomer**

| | | |
|---|---|---|
| 100 Teile | Tuftec P 1500 | SBBS mit 30 Gew.-% Blockpolystyrolgehalt der Firma Asahi Das SBBS enthält ca. 68 Gew.-% Zweiblockgehalt. |

Als Lösungsmittel wurde ein Gemisch aus Toluol und Aceton im Verhältnis 2:1 verwendet.

**M3: nichtklebendes Elastomer**

| | | |
|---|---|---|
| 100 Teile | Oppanol B 150 | PIB von BASF, Mn = 425.000 g/mol |

Als Lösungsmittel wurde Siedegrenzbenzin verwendet.

Es wurde die Wasserdampfpermeationsrate (WVTR) bei 38°C und 90% relativer Luftfeuchtigkeit nach ASTM F-1249 gemessen. Der angegebene Wert ist der Mittelwert aus zwei Messungen.

Die Klebkräfte auf Stahl wurden analog ISO 29862 (Methode 3) bei 23 °C und 50 % relativer Luftfeuchte bei einer Abzugsgeschwindigkeit von 300 mm/min und einem Abzugswinkel von 180° bestimmt. Als Verstärkungsfolie wurde eine geätzte PET-Folie mit einer Dicke von 50 µm verwendet, wie sie von der Fa. Coveme (Italien) erhältlich ist. Die Verklebung des Messstreifens wurde dabei mittels einer Anrollmaschine bei einer Temperatur von 23 °C vorgenommen. Die Klebebänder wurden sofort nach der Applikation abgezogen. Der angegebene Wert ist der Mittelwert aus drei Messungen.

| Bezeichnung | WVTR [g/m² d] | Klebkraft/Stahl [N/cm] |
|---|---|---|
| M1 | 68 | 7,1 |
| M2 | 85 | < 0,1 (Messgrenze) |
| M3 | 6 | < 0,1 |

Die ermittelten Klebkräfte auf Stahl zeigen, dass es sich bei den Massen M2 - M3 um nicht klebende Materialien handelt.

Folgende Gettermaterialien wurden verwendet:

| Bezeichnung | Beschreibung | Handelsname | Lieferant |
|---|---|---|---|
| G1 | Calciumoxid | Calcium oxide nanopowder | Sigma-Aldrich |
| G2 | Zeolith 3A | Purmol 3 STH | Zeochem |

Die Gettermaterialien wurden mittels einer schnelllaufenden Dispergierscheibe eines Laborrührwerks in die Masselösungen eingearbeitet. Die Masselösungen wurden zuvor mittels ca. 1 mm großer Zeolithkugeln getrocknet, welche vor dem Beschichtungsprozess wieder ausgefiltert wurden. Die Gettermaterial-haltigen Schichten wurden in einer Dicke von 100 µm hergestellt.

Als Trägermaterial B1 wurde eine circa 12 µm dicke, mit einer anorganischen Barriereschicht beschichtete Polyesterfolie (GX-P-F der Firma Toppan Printing) verwendet. Die Folie hat eine Wasserdampfpermeationsrate von 0,06 g/m²d. Die Gettermaterial enthaltenden Schichten wurden auf die Seite mit der anorganischen Barriereschicht der Folie aus der Lösung beschichtet und getrocknet.

Als Trägermaterial B2 wurde eine BOPP-Folie mit einer Dicke von 36 µm der Firma Pao-Yan, Taiwan, verwendet, die einen WVTR von 68 g/m² d aufweist.

Tabelle 1 zeigt die hergestellten Gettermaterial-haltigen Flächengebilde als einzelne Schicht bzw. als Aufbau nach spezifischen Figuren im Überblick

**Tabelle 1: Gettermaterial-gefüllte Flächengebilde**

| Bezeichnung | nicht klebendes Elastomer | Matrixmaterial | Getter-material | Anteil Getter [Gew.-%] | Aufbau nach Fig.-Nr. | Trägerfolie |
|---|---|---|---|---|---|---|
| T1 | - | M2 | G2 | 10 | einzelne Schicht | - |
| T2 | - | M2 | G2 | 20 | einzelne Schicht | - |
| T3 | - | M2 | G2 | 40 | einzelne Schicht | - |
| T4 | - | M3 | G1 | 10 | einzelne Schicht | - |
| T5 | - | M3 | G1 | 20 | einzelne Schicht | - |
| T6 | - | M3 | G1 | 40 | einzelne Schicht | - |
| T7 | M3 | M1 | G2 | 20 | 1 | B1 |
| T8 | M3 | M1 | G2 | 40 | 1 | B1 |
| T9 | M3 | M1 | G2 | 20 | 3 | B2 |
| T10 | M3 | M1 | G2 | 40 | 3 | B2 |
| T11 | - | M1 | G2 | 20 | 4 | B2 |
| T12 | - | M1 | G2 | 40 | 4 | B2 |
| V1 | | M1 | G2 | 20 | - | B2 |
| V2 | - | - | - | - | einzelne Schicht | - |

Als Vergleichsbeispiel V1 wurde ein klebendes gettermaterialhaltiges Flächengebilde aus der gettergefüllten Masse M1, welche auf das Trägermaterial B2 laminiert wurde, hergestellt.

Als weiteres Vergleichsbeispiel V2 wurde ein konventionelles Druckerpapier mit einem Flächengewicht von 80 g/m² verwendet. Dieses wurde zum einen 24 h bei 23 °C und 50 % rh konditioniert sowie zum anderen 1 h bei 120 °C im Trockenschrank vorgetrocknet.

Wenn ein klebendes Matrixmaterial verwendet wurde (M1), wurde eine 50 µm dicke Schicht eines nicht klebenden Elastomers bzw. die entsprechende Trägerfolie mittels eines Labor-Walzenlaminators darüber laminiert, wobei darauf geachtet wurde, die gettermaterialhaltige Schicht nach deren Trocknung so kurz wie möglich der Umgebungsatmosphäre auszusetzen.

### T13: Gettermaterial-haltige mehrschichtige Polyolefinfolie

Weiterhin wurde eine polyolefinbasierte Folie (PO) durch Flachfoliencoextrusion gefertigt. Sie bestand aus einer 50 µm dicken Basisschicht und zwei 10 µm dicken Außenschichten. Die Basisschicht bestand aus 79,7 Gew.-% Polypropylenblockcopolymer Novolen 2309 L (BASF, Schmelzindex 6 g/10 min bei 230 °C und 2,16 kg, Ethylengehalt ca. 6,5 Gew.-%), 20 Gew.-% Gettermaterial G2 und 0,3 % (w/w) des HALS-Stabilisators Tinuvin 770. Das Basisschichtmaterial wurde auf einer Zweischneckenextrusionsanlage der Fa. Coperion (d= 25 mm, L/d = 37) in-line mit der Flachfolienextrusion compoundiert und mittels einer zwischengeschalteten Schmelzepumpe in den Feedblock der Coextrusionseinheit gefördert. Das Gettermaterial wurde dem Zweischneckenextruder mittels eines Sidefeeders nach dem Aufschmelzen und Homogenisieren der Polymerkomponente zugeführt.

Die Außenschicht bestand aus 85 Gew.-% Ethylen-multi-Blockcopolymer Infuse D9107 (The Dow Chemical Company, d = 0,866 g/cm3) und 15 Gew.-% Polyethylen LD251 (ExxonMobil, d = 0,9155). Das Außenschichtmaterial wurde auf zwei Extrusionsanlagen der Fa. Dr. Collin extrudiert und in den Feedblock der Coextrusionseinheit gefördert.

Als ein von Permeat zu befreiendes Flächengebilde wurde eine circa 50 µm dicke, mit einer anorganischen Barriereschicht beschichtete Polyesterfolie (Cellel T0500 der Firma Kureha, Japan) verwendet, wie sie auch zur Verkapselung in organischen elektronischen Aufbauten zur Anwendung kommt. Die Folie wurde vor der Verwendung 24 Stunden bei 23 °C und 50 % rF konditioniert.

Als weiteres von Permeat zu befreiendes Flächengebilde wurde eine 50 µm dicke Schicht einer Haftklebemasse zur Verkapselung von organischen elektronischen Aufbauten verwendet, wie sie in DE 10 2008 047 964 A1, Beispiel 3 beschrieben ist. Die Klebemasse war dabei auf beiden Seiten mit einem konventionellen Liner des Types SILPHAN S36 M372 (36 µm PET) abgedeckt. Das Flächengebilde wurde vor der Verwendung 24 Stunden bei 23 °C und 50 % rF konditioniert. Ca. 10 x 10 cm² große Abschnitte der hergestellten gettermaterialhaltigen Flächengebilde wurden bei 23°C und 50 % rh auf die nicht anorganisch beschichtete Seite eines ebenso großen Abschnitts der Polyesterfolie bzw. auf den Liner der Haftklebemasseschicht aufgelegt und somit mit dem zu trocknenden Flächengebilde in Kontakt gebracht.
Mit den gettermaterialhaltigen Flächengebilden T2, T5, T7 und T9 wurde zusätzlich der Versuch unternommen, die Flächengebilde zunächst 8 Stunden bei 23°C und 50 % rF offen zu lagern und erst dann auf die Polyesterfolie aufzulegen.

Die so hergestellten Verbunde wurden über 14 Tage bei 23 °C in einer permeationsdichten Verpackung (eingeschweißt in einer Aluminiumverbundfolie) gelagert, wobei die Musterbeutel über die gesamte Fläche des innenliegenden Musters mit einem Gewicht von ca. 100 g beschwert wurden, um den Kontakt aufrechtzuerhalten. Die Muster wurden dann in einer Glovebox (Atmosphäre: Wasserdampf < 5 ppm, Sauerstoff < 1 ppm) ihrer Verpackung entnommen und es wurde jeweils das gettermaterialhaltige Flächengebilde von der Polyesterfolie entfernt. Ein Abschnitt der Polyesterfolie wurde unverzüglich zur Wassergehaltsbestimmung in Glasbehälter eingesiegelt. Bei der Klebemasse wurden beide Liner entfernt und der Wassergehalt der Klebemasseschicht bestimmt.

### Messung des Wassergehalts

Der Wassergehalt wurde ermittelt nach DIN 53715 (Karl-Fischer-Titration). Die Messung erfolgte an einem Karl-Fischer Coulometer 851 in Verbindung mit einem Ovensampler (Ofentemperatur 140 °C). Mit einer Einwaage von ca. 0,3 g wurde jeweils eine Dreifachbestimmung durchgeführt. Als Wassergehalt wird der arithmetische Mittelwert der Messungen angegeben.

Tabelle 2 stellt die Ergebnisse dar:

**Tabelle 2: Ergebnisse des Trocknungsverfahrens**

| Bezeichnung des applizierten und wieder entfernten gettermaterialhaltigen Flächengebildes | zutrocknendes Flächengebilde | Wassergehalt zutrocknendes Flächengebilde [ppm] |
|---|---|---|
| - | PET-Folie | 3290 (konditionierte Folie) |
| T1 | | 194 |
| T2 | | 18 |
| T3 | | 9 |
| T4 | | 73 |
| T5 | | 10 |
| T6 | | 8 |
| T7 | | 24 |
| T8 | | 17 |
| T9 | | 20 |
| T10 | | 6 |
| T11 | | 15 |
| T12 | | 10 |
| T13 | | 9 |
| T2 - 8 h konditioniert | | 836 |
| T5 - 8 h konditioniert | | 90 |
| T7 - 8 h konditioniert | | 18 |
| T9 - 8 h konditioniert | | 461 |
| V1 | | 16 |
| V2 - 24 h konditioniert | | 2810 |
| V2 - 1 h getrocknet | | 460 |
| | | |
| - | Haftklebemasse | 914 (konditionierte Haftklebemasse) |
| T2 | | 32 |
| T3 | | 13 |
| T6 | | 24 |
| T8 | | 14 |
| T10 | | 26 |
| T12 | | 33 |

Die Ergebnisse zeigen, dass mit dem erfindungsgemäßen Verfahren hervorragende Trocknungsergebnisse erzielt werden können, wie sie mit Verfahren nach dem Stand der Technik (V2) nicht erreicht werden können. Selbst mit vorgetrocknetem Papier wird kein Wassergehalt unterhalb von 200 ppm, insbesondere nicht unterhalb von 50 ppm erreicht, wie er für Materialien, die in einem organischen elektronischen Aufbau eingesetzt werden, erforderlich ist.

Der Wassergehalt der mit Gettermaterial gefüllten Flächengebilde T1 - T6 wurde vor der Applikation ebenfalls ermittelt: Er lag jeweils unterhalb von 10 ppm. Bei den Flächengebilden T7 - T8 lag er unterhalb von 1000 ppm, bei T9-T12 unterhalb von 500 ppm. Das getrocknete Papier V2 zeigte dagegen einen Wassergehalt von etwa 9200 ppm. Dies zeigt, dass ein Permeatgehalt von weniger als 1000 ppm vorteilhaft für das Erreichen sehr geringer Permeatgehalte ist.

Überraschend zeigen die mit einem erfindungsgemäßen Verfahren durchgeführten Versuche keine grundsätzlich schlechtere Befreiung vom Permeat als das Vergleichsbeispiel mit einer gettermaterialhaltigen Klebemasse (V1), obwohl der Fachmann erwartet hätte, dass ein bloßes Auflegen des gettermaterialhaltigen Flächengebildes aufgrund der nicht vorhandenen oder kaum ausgeprägten Fließfähigkeit einen geringeren Kontakt zum Verklebungssubstrat aufbaut und somit der Stofftransport vermindert wird. Das Entfernen des haftklebrigen gettermaterialhaltigen Flächengebildes vom PET-Testsubstrat war aufgrund der klebenden Eigenschaften im Vergleich zu den nicht klebenden Flächengebilden jedoch deutlich erschwert.

Beide verwendeten Gettermaterialien erweisen sich als gut geeignet. Überraschend zeigen auch Versuche mit einem geringen Anteil an Gettermaterial im Klebeband (T1, T4) eine im Vergleich zu solchen mit höherem Füllgrad (T2, T3 bzw. T5, T6) nur gering verminderte Wirksamkeit.

Überraschend zeigten auch Flächengebilde mit dem Aufbau nach Figur 1 (T7, T8) bzw. Figur 3 (T9, T10) bzw. Figur 4 (T11, T12), bei dem der Stofftransport zunächst durch eine wenig permeable Schicht erfolgen muss und diese Schicht und die Trägerfolie zunächst selbst von Permeat befreit werden müssen, keine nennenswert schlechteren Eigenschaften.

Im Vergleich der Verfahren mit den Flächengebilden T2 und T5, die nach achtstündiger Konditionierung auf das Testsubstrat laminiert wurden, zeigt sich der Vorteil einer Klebemasse mit einer geringen Permeationsrate: T2 zeigt nach der Konditionierung eine wesentliche Verringerung der Trocknungsleistung, während das Klebeband T5 mit der wesentlich weniger permeablen Masse kaum einen Abfall der Trocknungsleistung zeigt.

Ähnlich verhält es sich mit dem wesentlich weniger permeablen Trägermaterial B1. Mit diesem wird nach der Konditionierung ein geringerer Abfall der Trocknungsleistung beobachtet als mit dem permeableren Trägermaterial B2 (T7 vs. T9)

In einem weiteren Versuch wurde ein Verbund aus dem gettermaterialhaltigen Flächengebilde T10 zusammen mit dem PET-Testsubstrat zu einer Rolle mit einer Lauflänge von ca. 20 m gewickelt, was einen Stapel von etwa 70 Lagen auf dem Rollenkern ergab. Die Lagerung erfolgte wie oben beschrieben.
Zur Messung des Wassergehalts wurden Muster aus Laufmeter 2 (Kernnähe), 10 (Rollenmitte) und 19 (Rollenaußenseite) entnommen. Es ergab sich, dass der Wassergehalt an allen drei Stellen innerhalb einer Breite von 8 - 13 ppm lag, was eine hervorragende Gleichmäßigkeit der Trocknung innerhalb der Rolle darstellt. Das erfindungsgemäße Verfahren ist somit auch hervorragend zur Trocknung von gestapelten Flächengebilden geeignet.

## Patentansprüche

1. Verfahren zum Entfernen von Permeaten aus einem Flächengebilde I, welches zumindest zum Teil im Aufbau einer organischen elektronischen Anordnung verwendet wird, umfassend:
das unmittelbare oder mittelbare flächige Inkontaktbringen des Flächengebildes I mit einem mindestens ein Gettermaterial enthaltenden und zur Aufnahme mindestens eines Permeats aus dem Flächengebilde I befähigten Flächengebilde II, wobei keine klebende Verbindung zwischen den Flächengebilden I und II zustande kommt.

2. Verfahren gemäß Anspruch 1, **dadurch gekennzeichnet, dass** das Flächengebilde II nicht in der organischen elektronischen Anordnung verbleibt.

3. Verfahren gemäß mindestens einem der vorstehenden Ansprüche, **dadurch gekennzeichnet, dass** das Inkontaktbringen der Flächengebilde I und II derart erfolgt, dass der Verbund aus Flächengebilde I und Flächengebilde II in alternierender Schichtung vorliegt.

4. Verfahren gemäß mindestens einem der vorstehenden Ansprüche, **dadurch gekennzeichnet, dass** das Gettermaterial ausgewählt ist aus der Gruppe bestehend aus
Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Aluminiumsulfat, Calciumsulfat, Kupfersulfat, Bariumsulfat, Magnesiumsulfat, Lithiumsulfat, Natriumsulfat, Cobaltsulfat, Titansulfat, Natriumcarbonat, Natriumsulfat, Kaliumcarbonat, Magnesiumcarbonat sowie
Kieselgur, Kieselsäuren (Silica), Zeolithen, Schichtsilikaten sowie Eisen, Calcium, Barium, Natrium, Magnesium, Bariumoxid, Calciumoxid, Eisenoxid, Magnesiumoxid, Natriumoxid, Titandioxid, Kaliumoxid, Strontiumoxid, aktiviertem Aluminiumoxid sowie
Kohlenstoffnanoröhrchen, Aktivkohle, Phosphorpentoxid, Silanen sowie Calciumhydrid, Bariumhydrid, Strontiumhydrid, Natriumhydrid, Lithiumaluminiumhydrid, Kaliumhydroxid, Natriumhydroxid sowie Aluminiumacetylacetonat sowie
Essigsäureanhydrid, Propionsäureanhydrid, Buttersäureanhydrid, Methyltetrahydrophthalsäureanhydrid, Polyacrylsäure und Polyvinylalkohol.

5. Verfahren gemäß mindestens einem der vorstehenden Ansprüche, **dadurch gekennzeichnet, dass** das Gettermaterial ausgewählt ist aus der Gruppe bestehend aus
Barium, Calcium, Calciumsulfat, Calciumchlorid, Calciumoxid, Natriumsulfat, Kaliumcarbonat, Kupfersulfat, Magnesiumperchlorat, Magnesiumsulfat, Lithiumchlorid, Kieselsäuren und Zeolithen sowie Mischungen von zwei oder mehreren der vorstehenden Substanzen.

6. Verfahren gemäß mindestens einem der vorstehenden Ansprüche, **dadurch gekennzeichnet, dass** die das Gettermaterial enthaltenden Schichten des Flächengebildes II jeweils zumindest 10 Gew.-% Gettermaterial enthalten, jeweils bezogen auf das Gesamtgewicht der betreffenden Schicht.

7. Verfahren gemäß mindestens einem der vorstehenden Ansprüche, **dadurch gekennzeichnet, dass** das Gettermaterial enthaltende Flächengebilde II vor der Applikation einen Permeatgehalt von weniger als 1000 ppm aufweist.

8. Verfahren gemäß mindestens einem der vorstehenden Ansprüche, **dadurch gekennzeichnet, dass** mindestens eine der nach dem Inkontaktbringen des Flächengebildes II mit dem Flächengebilde I auf der dem Flächengebilde I abgewandten Seite der Gettermaterial-haltigen Schicht angeordnete Schicht des Flächengebildes II eine Wasserdampfpermeationsrate (WVTR) von weniger als 50 g/(m²*d) aufweist.

9. Verfahren gemäß mindestens einem der vorstehenden Ansprüche, **dadurch gekennzeichnet, dass** das Matrixmaterial der Gettermaterial enthaltenden Schicht und/oder das Material der für den Kontakt mit dem Flächengebilde I vorgesehenen Außenschicht des Flächengebildes II ein Elastomer ist.

10. Flächengebilde, umfassend eine nicht klebende, elastomere Kontaktschicht sowie mindestens eine weitere, mindestens ein Gettermaterial enthaltende und zur Aufnahme mindestens eines Permeats durch die elastomere Kontaktschicht hindurch befähigte Schicht, wobei die elastomere Kontaktschicht bei Raumtemperatur einen geringeren Elastizitätsmodul aufweist als zumindest eine weitere im Aufbau des Flächengebildes enthaltene Schicht;
das Gettermaterial als dispergierte Phase in einem Matrixmaterial enthalten ist und das Matrixmaterial eine Haftklebemasse ist.

11. Verwendung eines Flächengebildes gemäß Anspruch 10 zum Entfernen von Permeaten aus einem Flächengebilde.

## Claims

1. Method for removing permeates from a flat structure I that is at least partially used in the structure of an organic electronic device, comprising:
the direct or indirect bringing into planar contact of the flat structure I with a flat structure II containing at least one getter material and capable of taking up at least one permeate from the flat structure I, wherein no adhesive bonding takes place between the flat structures I and II.

2. Method according to Claim 1, **characterized in that** the flat structure II does not remain in the organic electronic device.

3. Method according to at least one of the above claims, **characterized in that** bringing into contact of the flat structures I and II takes place in such a way that the composite of the flat structure I and the flat structure II is configured in alternating layers.

4. Method according to at least one of the above claims, **characterized in that** the getter material is selected from the group consisting of cobalt chloride, calcium chloride, calcium bromide, lithium chloride, lithium bromide, magnesium chloride, barium perchlorate, magnesium perchlorate, zinc chloride, zinc bromide, aluminium sulfate, calcium sulfate, copper sulfate, barium sulfate, magnesium sulfate, lithium sulfate, sodium sulfate, cobalt sulfate, titanium sulfate, sodium carbonate, sodium sulfate, potassium carbonate, magnesium carbonate, as well as diatomaceous earth, silicic acids, and zeolites, and layered silicates, as well as
iron, calcium, barium, sodium , magnesium, barium oxide, calcium oxide, iron oxide, magnesium oxide, sodium oxide, titanium dioxide, potassium oxide, strontium oxide, activated aluminum oxide, as well as
carbon nanotubes, activated carbon, phosphorus pentoxide, silanes, as well as
calcium hydride, barium hydride, strontium hydride, sodium hydride, lithium aluminium hydride, potassium hydroxide, sodium hydroxide, as well as
aluminium acetyl acetonate and acetic anhydride, propionic anhydride, butyric anhydride, methyltetrahydrophthalic anhydride, polyacrylic acid, and polyvinyl alcohol.

5. Method according to at least one of the above claims, **characterized in that** the getter material is selected from the group consisting of barium, calcium, calcium sulfate, calcium chloride, calcium oxide, sodium sulfate, potassium carbonate, copper sulfate, magnesium perchlorate, magnesium sulfate, lithium chloride, silicic acids, and zeolites, as well as mixtures of two or more of the above substances.

6. Method according to at least one of the above claims, **characterized in that** each of the getter-material-containing layers of the flat structure II contains at least 10 wt.% of getter material, relative in each case to the entire weight of the respective layer.

7. Method according to at least one of the above claims, **characterized in that** the getter-material-containing flat structure II has a permeate content of less than 1000 ppm before application.

8. Method according to at least one of the preceding claims, **characterized in that**
at least one layer of the flat structure II arranged on the side of the getter-material-containing layer facing away from the flat structure I after bringing into contact of the flat structure II and the flat structure I has a water vapor transmission rate (WVTR) of less than 50 g/(m²*d).

9. Method according to at least one of the preceding claims, **characterized in that** the matrix material of the getter-material-containing layer and/or the material for the outer layer of the flat structure II provided for contact with the flat structure I is an elastomer.

10. Flat structure, comprising a non-adhesive, elastomeric contact layer and at least one further layer containing at least one getter material and capable of taking up at least one permeate through the elastomeric contact layer, wherein the elastomeric contact layer has a lower elastic modulus at room temperature than at least one further layer contained in the composition of the flat structure; the getter material is contained in the matrix material as a dispersed phase and the matrix material is a pressure-sensitive adhesive.

11. Use of a flat structure according to Claim 10 for the removal of permeates from a flat structure.

## Revendications

1. Procédé d'élimination de perméats d'une structure plane I, qui est utilisée au moins en partie dans la construction d'un agencement électronique organique, comprenant :
la mise en contact directe ou indirecte à plat de la structure plane I avec une structure plane II contenant au moins un matériau piégeur et apte à l'absorption d'au moins un perméat à partir de la structure plane I, aucune liaison adhésive n'étant établie entre les structures planes I et II.

2. Procédé selon la revendication 1, **caractérisé en ce que** la structure plane II ne reste pas dans l'agencement électronique organique.

3. Procédé selon au moins l'une quelconque des revendications précédentes, **caractérisé en ce que** la mise en contact des structures planes I et II a lieu de telle sorte que le composite de la structure plane I et de la structure plane II se présente en couches alternées.

4. Procédé selon au moins l'une quelconque des revendications précédentes, **caractérisé en ce que** le matériau piégeur est choisi dans le groupe constitué par :
le chlorure de cobalt, le chlorure de calcium, le bromure de calcium, le chlorure de lithium, le bromure de lithium, le chlorure de magnésium, le perchlorate de baryum, le perchlorate de magnésium, le chlorure de zinc, le bromure de zinc, le sulfate d'aluminium, le sulfate de calcium, le sulfate de cuivre, le sulfate de baryum, le sulfate de magnésium, le sulfate de lithium, le sulfate de sodium, le sulfate de cobalt, le sulfate de titane, le carbonate de sodium, le sulfate de sodium, le carbonate de potassium, le carbonate de magnésium, ainsi que
la diatomée, les acides siliciques (silices), les zéolithes, les phyllosilicates, ainsi que
le fer, le calcium, le baryum, le sodium, le magnésium, l'oxyde de baryum, l'oxyde de calcium, l'oxyde de fer, l'oxyde de magnésium, l'oxyde de sodium, le dioxyde de titane, l'oxyde de potassium, l'oxyde de strontium, l'oxyde d'aluminium activé, ainsi que
les nanotubes de carbone, le charbon actif, le pentoxyde de phosphore, les silanes, ainsi que
l'hydrure de calcium, l'hydrure de baryum, l'hydrure de strontium, l'hydrure de sodium, l'hydrure de lithium et d'aluminium, l'hydroxyde de potassium, l'hydroxyde de sodium, ainsi que l'acétylacétonate d'aluminium, ainsi que
l'anhydride de l'acide acétique, l'anhydride de l'acide propionique, l'anhydride de l'acide butyrique, l'anhydride de l'acide méthyltétrahydrophtalique, l'acide polyacrylique et l'alcool polyvinylique.

5. Procédé selon au moins l'une quelconque des revendications précédentes, **caractérisé en ce que** le matériau piégeur est choisi dans le groupe constitué par :
le baryum, le calcium, le sulfate de calcium, le chlorure de calcium, l'oxyde de calcium, le sulfate de sodium, le carbonate de potassium, le sulfate de cuivre, le perchlorate de magnésium, le sulfate de magnésium, le chlorure de lithium, les acides siliciques et les zéolithes, ainsi que les mélanges de deux ou plus des substances susmentionnées.

6. Procédé selon au moins l'une quelconque des revendications précédentes, **caractérisé en ce que** les couches contenant le matériau piégeur de la structure plane II contiennent à chaque fois au moins 10 % en poids de matériau piégeur, à chaque fois par rapport au poids total de la couche en question.

7. Procédé selon au moins l'une quelconque des revendications précédentes, **caractérisé en ce que** la structure plane II contenant le matériau piégeur présente avant l'application une teneur en perméat inférieure à 1 000 ppm.

8. Procédé selon au moins l'une quelconque des revendications précédentes, **caractérisé en ce qu'**au moins une couche de la structure plane II agencée sur le côté de la couche contenant le matériau piégeur opposé à la structure plane I après la mise en contact de la structure plane II avec la structure plane I présente un taux de perméation de la vapeur d'eau (WVTR) inférieur à 50 g/(m²*d).

9. Procédé selon au moins l'une quelconque des revendications précédentes, **caractérisé en ce que** le matériau de matrice de la couche contenant le matériau piégeur et/ou le matériau de la couche extérieure de la structure plane II prévue pour le contact avec la structure plane I est un élastomère.

10. Structure plane, comprenant une couche de contact élastomère non collante, ainsi qu'au moins une autre couche contenant au moins un matériau piégeur et apte à l'absorption d'au moins un perméat au travers de la couche de contact élastomère, la couche de contact élastomère présentant à température ambiante un module d'élasticité plus faible qu'au moins une autre couche contenue dans la construction de la structure plane ;
le matériau piégeur étant contenu dans un matériau de matrice sous la forme d'une phase dispersée et le matériau de matrice étant une masse adhésive de contact.

11. Utilisation d'une structure plane selon la revendication 10 pour l'élimination de perméats d'une structure plane.
